# EUROPÄISCHE PATENTSCHRIFT

(11) **EP 2 529 609 B1**
(45) Veröffentlichungstag und Bekanntmachung des Hinweises auf die Patenterteilung: **15.05.2019**
(21) Anmeldenummer: 11704943.7
(22) Anmeldetag: 26.01.2011
(51) Int. Cl.: H05K 5/02, E05B 19/04, E05B 19/24, B41J 3/28, B41J 3/407, G07C 9/00

(54) **MOBILER IDENTIFIKATIONSGEBER**
MOBILE IDENTIFICATION INDICATOR
ÉMETTEUR D'IDENTIFICATION MOBILE

(30) Priorität: 26.01.2010 DE 102010001233
(43) Veröffentlichungstag der Anmeldung: 05.12.2012
(73) Patentinhaber: Huf Hülsbeck & Fürst GmbH & Co. KG, 42551 Velbert (DE)
(72) Erfinder: MÖNIG, Stefan, 58332 Schwelm (DE); GELDMACHER, Alexander, 42113 Wuppertal (DE)
(74) Vertreter: Patentanwälte Bals & Vogel
(86) Internationale Anmeldenummer: PCT/EP2011/051084
(87) Internationale Veröffentlichungsnummer: WO 2011/092215

(56) Entgegenhaltungen:
- EP-A1- 1 038 782
- EP-A1- 1 892 107
- DE-A1-102007 021 765
- DE-U1- 20 120 565
- US-A- 5 784 171
- US-A1- 2007 160 831
- US-A1- 2007 227 866

## Beschreibung

Die Erfindung betrifft einen mobilen Identifikationsgeber zur Ent- und Verriegelung einer Schließvorrichtung eines Kraftfahrzeuges, mit einer Elektronikeinheit, die innerhalb eines Gehäuses angeordnet ist. Ferner bezieht sich die Erfindung auf ein Verfahren zur Herstellung eines derartigen mobilen Identifikationsgebers.

In der DE 44 29 999 C1 ist ein Schlüssel für ein Autoschloss offenbart. Hierbei ist der Schlüsselrohling an einem Griff befestigt, der aus zwei Holzplättchen zusammengeleimt ist. Zudem weist der Griff eine Vertiefung auf, in die ein Plättchen eingelegt ist. Dieses Plättchen kann beispielsweise ein aufgedrucktes Emblem aufweisen. Der gesamte Griff mit eingelegtem Plättchen wird von einem schützenden Lacküberzug umhüllt.

In der DE 10 2008 025 033 A1 ist ein kombinierter mechanischer und elektronischer Schlüssel für Kraftfahrzeuge offenbart, der einen Schlüssel aufweist, der schwenkbar in dem Gehäuse des kombinierten Schlüssels gelagert ist. Hierbei setzt sich das Gehäuse aus unterschiedlichen Schalen zusammen, wobei an einer Schale ein Logoelement befestigt ist.

Das Dokument US 2007/0227866 A1 offenbart einen mobile Identifikationsgeber mit einer aufgedruckten Informationsbeschichtung.

Nachteiligerweise hat sich gezeigt, dass die Anordnung von Informationselementen auf dem Gehäuse eines Kraftfahrzeugschlüssels einen hohen Montageaufwand erfordert. Ferner ist das Design eines derartigen Informationselementes oft aufgrund der jeweiligen Geometrie des Gehäuses nicht frei wählbar.

Die Aufgabe der vorliegenden Erfindung ist es die oben genannten Nachteile zu vermeiden, insbesondere einen mobilen Identifikationsgeber sowie ein Verfahren zur Herstellung eines mobilen Identifikationsgebers bereitzustellen, der einfach herzustellen ist, eine ästhetisch ansprechende Oberflächenbeschaffenheit aufweist und widerstandsfähig gegenüber äußeren Einflüssen, wie Lichteinflüssen, mechanischen Einflüssen sowie chemischen Zersetzungen ist.

Zur Lösung dieser Aufgabe wird ein mobiler Identifikationsgeber mit den Merkmalen des Anspruches 1 sowie ein Verfahren zur Herstellung eines mobilen Identifikationsgebers mit den Merkmalen des Anspruches 9 vorgeschlagen. In den abhängigen Ansprüchen sind bevorzugte Weiterbildungen ausgeführt.

Erfindungsgemäß ist vorgesehen, dass das Gehäuse eine definierte Außenfläche aufweist, auf der eine Funktionsbeschichtung aufgebracht ist, wobei die Funktionsbeschichtung mindestens eine Schicht aufweist, wobei eine gedruckte Informationsschicht zur Individualisierung des Identifikationsgebers vorgesehen ist. Ein wesentlicher Vorteil dieser Erfindung ist, dass aufgrund unterschiedlicher Möglichkeiten des Bedruckens eine Vielzahl an Mustern, Oberflächenstrukturen etc. mit Hilfe der Informationsschicht wiedergegeben werden können. Zum Beispiel ist ein "Holzdesign" mit Hilfe der Informationsschicht realisierbar.

Weiterhin weist die Funktionsbeschichtung eine Farbschicht auf, wobei die Farbschicht unmittelbar auf der Außenfläche des Gehäuses aufgetragen ist.
Ebenso ist es denkbar, dass die Funktionsbeschichtung eine Haftschicht aufweist.

Zusätzlich weist die Funktionsbeschichtung eine Schutzschicht auf, die auf der Informationsschicht angeordnet ist, so dass die die Informationsschicht zwischen der Außenfläche des Gehäuses und der Schutzschicht angeordnet ist. Weiterhin weist die Funktionsschicht eine weitere Schutzschicht auf, die unterhalb der Informationsschicht angeordnet ist, so dass die die Informationsschicht zwischen beiden Schutzschichten positioniert ist.

In der Regel ist das Gehäuse des mobilen Identifikationsgebers aus einem Kunststoff, insbesondere aus einem schwarzen Kunststoff. Über die Auftragung der Farbschicht erhält das Gehäuse eine Art Basisfarbe, die beispielsweise schwarz, blau, rot, etc. sein kann. Diese Farbschicht kann zum einen direkt auf das Gehäuse aufgebracht werden oder auf die Haftschicht, die zuvor als Haftvermittler auf das Gehäuse aufgebracht wurde. Gemäß der Erfindung besteht zum Beispiel die Möglichkeit auf die Farbschicht direkt die Informationsschicht aufzubringen. Ebenfalls ist es denkbar, dass zunächst eine Schutzschicht auf die Farbschicht aufgebracht wird und anschließend die Informationsschicht auf die Schutzschicht aufgetragen wird. Nachdem die Informationsschicht auf dem Gehäuse aufgetragen ist, kann die weitere Schutzschicht auf die Informationsschicht aufgetragen werden.

Vorteilhafterweise kann vorgesehen sein, dass die Funktionsbeschichtung eine aufgedruckte Schicht ist, in der das Material der Schutzschicht und/oder der Informationsschicht und/oder der Farbschicht und/oder der Haftschicht integriert ist. Das bedeutet, dass lediglich eine Schicht die Funktionsbeschichtung bildet und das Material der Schutzschicht und/oder der Informationsschicht und/oder der Farbschicht und/oder der Haftschicht mit einem Druckprozess auf die definierte Außenfläche des Gehäuses aufbringbar ist.

In einer möglichen Ausgestaltung ist es denkbar, dass die komplette Außenfläche mit der Haftschicht und/oder der Farbschicht und/oder der einen Schutzschicht versehen wird. Im folgenden Schritt kann eine definierte Fläche mit der Informationsschicht zur Individualisierung des Identifikationsgebers bedruckt werden.

Die Erfindung kann sich auf einen mobilen Identifikationsgeber mit mindestens einem Tastenelement beziehen, mit dem eine definierte Funktion ausgelöst werden kann. Ebenfalls ist es denkbar, dass ein mobiler Identifikationsgeber zum Einsatz kommt, der tastenfrei ausgeführt ist.

Die Informationsschicht, die durch die Schutzschicht geschützt ist, insbesondere versiegelt ist, weist einen Informationsgehalt, wie beispielsweise ein Logo, einen Schriftzug, eine Farbe, eine Marke, eine Grafik, einen Namen des Schlüsselbesitzers, das Autokennzeichen des Kraftfahrzeuges oder eine definierte Signalfarbe zur Individualisierung des Identifikationsgebers auf. Somit kann auf bekannte Schlüsselanhänger, die beispielsweise derartige Informationen tragen können, verzichtet werden, da unmittelbar am Gehäuse des mobilen Identifikationsgebers die in Rede stehende Information aufgebracht ist.

Ferner kann erfindungsgemäß vorgesehen sein, dass das Gehäuse eine definierte Außenfläche aufweist, auf der die Funktionsbeschichtung aufgebracht ist, wobei die Funktionsbeschichtung mindestens zwei Schichten aufweist, wobei die Informationsschicht zur Individualisierung des Identifikationsgebers vorgesehen ist, auf der eine Schutzschicht angeordnet ist, wobei die Informationsschicht zwischen der Außenfläche des Gehäuses und der Schutzschicht angeordnet ist. Die Schutzschichten können beispielsweise ein Klarlack oder eine Lackschicht sein, die insbesondere zumindest teilweise transparent ausgeführt sind. Die Schutzschicht ist hierbei derart in ihrer Zusammensetzung ausgeführt, dass sie durch ihre Beschaffenheit resistent gegenüber mechanischen Einflüssen und chemische Beeinträchtigungen ist, wobei gleichzeitig eine entsprechende Optik des mobilen Identifikationsgebers geschaffen wird. Die Aufbringung der Funktionsbeschichtung ist darüber hinaus montagefreundlich, wodurch der Gesamtprozess zur Herstellung eines Identifikationsgebers wesentlich vereinfacht ist.

Vorteilhafterweise kann die Schutzschicht mindestens eine der folgenden Komponenten aufweisen: Bindemittel, Pigmente, Lösemittel, Füllstoffe und Additive. Hierbei bildet die Schutzschicht eine Beschichtungslage, die sehr dünn auf der Informationsschicht und/oder auf der Farbschicht aufgetragen ist. Vorteilhafterweise ist die Funktionsbeschichtung sehr dünn, d.h. weniger als 50µm.

Alternativ zu der Erfindung kann eine auf der Außenfläche des Gehäuses angeordnete Haftschicht vorgesehen sein, wobei auf der Haftschicht die Informationsschicht oder die Farbschicht angeordnet sein kann. Somit kann die Funktionsbeschichtung mit einer Haftschicht ausgeführt sein, die zwischen der Außenfläche des Gehäuses und der Informationsschicht aufgetragen ist. Die Haftschicht dient bevorzugt dazu, um die Affinität und/oder die Haftung der Informationsschicht oder der Farbschicht an der Außenfläche des Gehäuses zu verbessern. Hierbei ist es denkbar, dass die Haftschicht geeignete Haftvermittler aufweist, vorzugsweise lösemittelbasiert, wasserbasiert oder UV-härtend. In einer möglichen Ausführungsform kann die Haftschicht folgendes umfassen:
Ca. 20 bis 30 Gewichtsprozent Bindemittel, vorzugsweise Haftharz;
ca. 1 bis 3 Gewichtsprozent Füllstoff, vorzugsweise anorganischer Füllstoff, bevorzugt pyrogene Kieselsäure;
ca. 50 bis 90 Gewichtsprozent Lösemittel, vorzugsweise organische Lösemittel.

Die Haftschicht kann auch lösemittelfrei sein.

In einer weiteren Ausgestaltung des mobilen Identifikationsgebers kann die Oberfläche der Außenfläche des Gehäuses derart aktiviert sein, dass die Benetzbarkeit und/oder das Haftvermögen, insbesondere im Bezug auf die Farbschicht erhöht ist. Hierdurch wird eine Vorbehandlung der definierten Außenfläche des Gehäuses durchgeführt, wobei insbesondere Oxidationsprozesse stattfinden können, die die Außenfläche des Gehäuses polarisieren. Hierbei kann eine oxidierende Behandlung mit einer hohen Energie an der definierten Außenfläche des Gehäuses durchgeführt werden. Es hat sich herausgestellt, dass insbesondere die aus Kunststoff bestehende Außenfläche des Gehäuses eine unpolare Oberfläche aufweist, die nur schwer verkleb- und/oder beschichtbar ist. Über einen entsprechenden Energieeintrag durch die Aktivierung der Oberfläche der Außenfläche des Gehäuses wird gleichzeitig eine strukturelle Veränderung der Außenfläche des Gehäuses erzielt, so dass im Ergebnis eine bessere Benetzbarkeit und ein verbessertes Haftvermögen der Außenfläche des Gehäuses geschaffen wird. Durch die entsprechende Aktivierung der Außenfläche wird eine physikalische Behandlung derart durchgeführt, dass die Oberflächenenergie der Oberfläche des Gehäuses erhöht wird, so dass eine zuverlässige Befestigung der Farbschicht auf der aktivierten Außenfläche des Gehäuses geschaffen wird. Ebenfalls ist es denkbar, dass die Oberfläche der Haftschicht und/oder der Informationsschicht und/oder der Farbschicht zusätzlich oder alternativ aktiviert wird.

Die Schutzschicht, die Farbschicht sowie die Haftschicht können beispielsweise durch Spritzen oder Sprühen auf das Gehäuse aufgetragen werden. Hierbei ist es denkbar, dass zum Aufsprühen Druckzerstäuber zur Anwendung kommen, die die jeweilige Schicht mittels eines Kompressors in einem Niederdruck, insbesondere zwischen 0,5 und 1 bar, in einem Hochdruck, insbesondere zwischen 4 und 8 bar oder in einem Airless-Spritzen, insbesondere zwischen 60 und 340 bar auftragen können. Ebenfalls ist es denkbar, dass die Schutzschicht und/oder Haftschicht und/oder Farbschicht durch Tauchlackierung auf das Gehäuse aufgetragen wird. Eine Elektrotauchlackierung, insbesondere anodische und/oder kathodische Tauchlackierung kann vorteilhaft sein, insbesondere bei Werkstücken, wie einem mobilen Identifikationsgeber, der unterschiedliche Designausgestaltungen je nach Modell aufweisen kann. Alternativ hierzu ist es denkbar, dass ein elektrostatisches Spritzverfahren zur Aufbringung der Schutzschicht und/oder der Haftschicht und/oder der Farbschicht zum Einsatz kommt. Hierbei kann ein elektrostatisches Hochspannungsfeld von ungefähr 70 bis 160 kV genutzt werden. Ein Vorteil dieses elektrostatischen Spritzverfahrens ist, dass dieser Prozess vollautomatisch mit Robotern erfolgen kann.

Vorteilhafterweise erfolgt die Aufbringung der Schutzschicht und/oder der Haftschicht und/oder der Farbschicht durch ein Bedrucken. Hierbei ist es denkbar, dass alle relevanten Schichten der Funktionsbeschichtung auf die Außenfläche des Gehäuses bedruckt werden, wobei in einer besonderen Ausführungsform der Erfindung lediglich ein Druckkopf zur Aufbringung der Funktionsbeschichtung auf das Gehäuse zum Einsatz kommt. Das bedeutet, dass in einer Vorrichtung zur Aufbringung der Funktionsbeschichtung sämtliche Schichten der Funktionsbeschichtung aufgetragen, insbesondere bedruckt werden können, wodurch der Prozess zur Aufbringung der genannten Funktionsbeschichtung auf den mobilen Identifikationsgeber wesentlich vereinfacht werden kann.

Gemäss der Erfindung ist die Informationsschicht aufgedruckt, wobei die Schutzschicht und/oder die Haftschicht und/oder die Farbschicht in einer Ausführungsform aufgesprüht sind. Die Informationsschicht kann beispielsweise über Druckwalzen oder berührungslos aufgetragen werden, insbesondere durch eine Injektbedruckung. Beispielsweise kann ein Farbmittel, insbesondere Tinte auf das Gehäuse aufgetragen werden, wodurch die Informationsschicht entsteht. Die Tinte kann zum Beispiel lichtaushärtend, insbesondere UV-lichtaushärtend ausgeführt sein. In diesem Ausführungsbeispiel kann eine Belichtungseinheit zum Einsatz kommen, der die erforderliche Energie zur Aushärtung der Tinte aufbringt. Hierdurch kann eine schnelle Verfestigung der Tinte erzielt werden, wodurch ein Verlaufen der Tinte auf dem Druckgut, insbesondere auf dem Gehäuse des mobilen Identifikationsgebers verhindert wird. Hierbei konnte überraschenderweise herausgestellt werden, dass die ausgesendete Strahlungsenergie der Belichtungseinheit zwei Vorteile bietet: Zum einen erfolgt eine zuverlässige Fixierung der aufgedruckten Tinte auf der Oberfläche des Gehäuses des Identifikationsgebers. Zum anderen dient die Strahlungsenergie zum Aus- und Durchhärten der aufgedruckten Tinte, damit sie auf der Außenfläche des Gehäuses zuverlässig haften bleibt. Zudem wird durch die entsprechende Emittierung von Strahlungsenergie auf die Funktionsbeschichtung, insbesondere auf die Informationsschicht ein scharfes und klares Druckbild erzielt.

In einer weiteren Ausführungsform der Erfindung kann die Funktionsbeschichtung, insbesondere die Informationsschicht mehrfach mit einer gewissen Strahlungsenergie bestrahlt werden. Es hat sich gezeigt, dass dadurch eine schnellere Aushärtung erzielbar ist, wobei gleichzeitig eine erhöhte Kratzfestigkeit der Funktionsbeschichtung erreicht wird.

Vorteilhafterweise kann das Gehäuse aus mindestens einer ersten und einer zweiten Einzelschale ausgeführt sein, wobei die Außenfläche der ersten Einzelschale die Funktionsbeschichtung aufweist. Hierbei setzt sich das Gehäuse aus unterschiedlichen Einzelschalen zusammen, die im zusammengesetzten Zustand die Elektronikeinheit des mobilen Identifikationsgebers vollständig umfassen. Die Einzelschalen werden beispielsweise während der Montage des mobilen Identifikationsgebers laserverschweißt. Alternative Befestigungsmöglichkeiten der Einzelschalen sind selbstverständlich denkbar. Zumindest eine der Einzelschalen trägt die Funktionsbeschichtung, die gut für den Benutzer des Identifikationsgebers sichtbar ist. Eine Einzelschale kann auch als abnehmbarer Batteriefachdeckel ausgeführt sein, der mit der oben genannten Funktionsbeschichtung ausgeführt sein kann. Innerhalb des Gehäuses, insbesondere unterhalb des Batteriefachdeckels befindet sich die Batterie, die die Elektronikeinheit, die sich innerhalb des Gehäuses befindet, mit der entsprechenden Spannung versorgt.

In einer weiteren die Erfindung verbessernden Maßnahme kann vorgesehen sein, dass die Außenfläche des Gehäuses aus einem Kunststoff besteht, insbesondere dass die erste Einzelschale aus einem Kunststoff besteht. Gemäß der vorliegenden Erfindung kann das Gehäuse des Identifikationsgebers aus einem thermoplastischen, elastomeren oder wärmehärtbaren Polymer sowie jedes Gemisches von solchen Polymeren bestehen. Unter der Bezeichnung "Polymer" sind gleichzeitig die Homopolymere und die Copolymere umfasst. Es hat sich gezeigt, dass gute Ergebnisse bei der Aufbringung der Funktionsbeschichtung mit thermoplastischen Polymeren erzielbar sind. Insbesondere wurden gute Ergebnisse bei der Aufbringung der Funktionsbeschichtung mit weich gemachten oder nicht weich gemachten Polymeren des Vinylchlorids (VC) mit Polymeren des Vinylidenflurids (VdF) und mit Polyolefinen erhalten. Mehrere verschiedene Kunststoffe können jedenfalls in homogenen oder heterogenen Gemischen verwendet werden, beispielsweise um die Schlagfestigkeit des Gehäuses des mobilen Identifikationsgebers zu verbessern.

Zu diesem oder diesen Kunststoffen können außerdem ggf. ein oder mehrere herkömmliche mineralische Füllstoffe, wie Calciumcarbonat, Titanoxid, Füllstoffe pflanzlichen Ursprungs, wie Holzsägemehl, Verstärkungsfasern wie beispielsweise Glas oder Kohlenstofffasern sowie ein oder mehrere herkömmliche Zusätze, wie Stabilisatoren, Gleitmittel, Antioxidantien hinzugefügt werden.

Insbesondere kann der Kunststoff erfindungsgemäß ausgewählt sein aus der Gruppe von Polyamiden, Polyolefinen, PP, PPS, Polyurethanen, ABS (Acrylnitril/Butadien/Styrol), PBT (Polybutylenterephthalat) und PC (Polycarbonaten). Bevorzugt eignen sich Polyamide zur Verbesserung der Benetzbarkeit und/oder des Haftvermögens.

In einer vorteilhaften Ausgestaltung ist die Schutzschicht, die die Informationsschicht und/oder die Farbschicht bedeckt, zumindest teilweise transparent ausgeführt. Somit kann eine zuverlässige Versiegelung und Schutz der Informationsschicht und der Farbschicht erzielt werden. Die Schutzschicht kann auch weitere Materialeigenschaften aufweisen, insbesondere eine hohe Kratzfestigkeit haben.

Erfindungsgemäß kann vorgesehen sein, dass die Informationsschicht eine Beschriftung, eine Farbe, eine Grafik, eine metallische Farbe oder ein Logoelement aufweist.

Der mobile Identifikationsgeber kann über das Tastenelement mit einem elektronischen Schließsystem für Kraftfahrzeuge zusammenwirken. Hierbei kann der mobile Identifikationsgeber auch mit "Keyless-Go" oder "Keyless-Entry"-Funktionalitäten ausgestattet sein. Im Gegensatz zur konventionellen Fernbedienung mit dem Identifikationsgeber ist bei der Keyless-Entry-Funktionalität keine aktive Bedienung des Tastenelements des Identifikationsgebers zur Öffnung/Entriegelung/Verriegelung einer Fahrzeugtür oder des Fahrzeugkofferraumes mehr notwendig. Vielmehr wird bei der Betätigung des Türgriffes an der Autotür eine Kommunikation zwischen dem Kraftfahrzeug und dem Identifikationsgeber gestartet und bei positiver Authentifizierung die elektrische Türöffnung des Kraftfahrzeuges aktiviert. Das bedeutet, dass der einen gültigen Identifikationsgeber mitführende Benutzer sein Kraftfahrzeug öffnen kann, ohne aktiv den tastenlosen Identifikationsgeber betätigt zu haben. Beispielsweise ist es in einer möglichen Ausführungsform denkbar, ein Zugangskontrollverfahren vorzusehen, das bei Betätigung des Türgriffes ein Sendeimpuls über eine induktive Antenne zum Identifikationsgeber übertragen wird, der Identifikationsgeber wird daraufhin geweckt und sendet ein Funksignal der fahrzeugseitigen Sende-/Empfangseinheit, die dieses Signal von einem Steuergerät für die Zugangsberechtigung weiterleitet. Wird hier der richtige Code erkannt, so wird die elektrische Türöffnung oder Kofferraumöffnung durch entsprechende Ansteuerung der Steuergeräte aktiviert. Dasselbe kann sich bei einer Türschließung durch Berührung des Türgriffes abspielen.

Für die Keyless-Go-Funktionalität wird ein fahrzeugseitiges Steuergerät über einen Startschalter im Ganghebel oder im Cockpit geweckt und sendet anschließend einen Impuls zum Identifikationsgeber, der sich innerhalb des Fahrzeuges befindet. Der Identifikationsgeber sendet ein Funksignal zurück. Bei richtiger Codeerkennung startet anschließend der Motor des Kraftfahrzeuges über das zentrale Steuergerät.

Die vorliegende Erfindung wird ebenfalls durch ein Verfahren mit den Merkmalen des Anspruches 9 gelöst. Erfindungsgemäß wird zunächst das Gehäuse, das ein Spritzgussteil aus Kunststoff ist, bereitgestellt. Anschließend erfolgt eine Aufbringung einer Funktionsbeschichtung auf eine definierte Außenfläche des Gehäuses, wobei eine Informationsschicht zur Individualisierung des Identifikationsgebers aufgedruckt wird. Durch die aufgedruckte Informationsschicht kann dem Identifikationsgeber ein individuelles Design ermöglicht werden. Neben Schriftzügen kann die Funktionsbeschichtung dem Betrachter z. B. ein metallisches Aussehen suggerieren, welches durch entsprechende Drucktechnik zu realisieren ist.

Weiterhin wird auf die Informationsschicht eine Schutzschicht zur Versiegelung und zum Schutz der Informationsschicht aufgebracht werden. Die Aufbringung der Informationsschicht erfolgt in einem ersten Schritt, wobei in einem zweiten Schritt die Schutzschicht aufgebracht wird.

Ausserdem wird vor einer Aufbringung der Informationsschicht zunächst eine Farbschicht direkt auf die Außenfläche des Gehäuses aufgebracht.

Das erfindungsgemäße Verfahren zeichnet sich vorteilhafterweise dadurch aus, dass auf einfache und schnelle Weise die Funktionsbeschichtung auf das Gehäuse aufbringbar ist. Hierbei sind diverse Geometrien des Gehäuses denkbar, die mit der Informationsschicht bedruckt werden können. Die einzelnen Schichten der Funktionsbeschichtung können hierbei sequentiell auf das Gehäuse aufgetragen werden.Vorzugsweise weist die Funktionsbeschichtung eine Dicke von weniger als 50 µm, bevorzugt weniger als 30 µm auf.

Auf die Farbschicht wird eine Schutzschicht aufgebracht, auf die die Informationsschicht zur Individualisierung des Identifikationsgebers aufgedruckt wird. Anschließend erfolgt eine weitere Aufbringung einer Schutzschicht auf die Informationsschicht.

In einer weiteren bevorzugten Ausführung der Erfindung kann vor einer Aufbringung der Funktionsbeschichtung es vorgesehen sein, dass die Außenfläche des Gehäuses, die mit der Informationsschicht versehen werden soll, zunächst gereinigt wird, insbesondere die Außenfläche des Gehäuses entfettet wird. Es hat sich gezeigt, dass eine gereinigte, entfettete Außenfläche des Gehäuses eine besonders hohe Haftwirkung für die Funktionsbeschichtung, insbesondere für die Haftschicht und/oder die Informationsschicht und/oder die Farbschicht bietet.

Ebenfalls ist es nach einer Ausführungsform der Erfindung denkbar, vor einer Aufbringung der Funktionsbeschichtung die Oberfläche der Außenfläche des Gehäuses zu aktivieren, wodurch die Benetzbarkeit und/oder das Haftvermögen, insbesondere in Bezug auf die Farbschicht erhöht wird. Hierbei kann die Aktivierung mindestens einen der folgenden Vorgänge umfassen: eine Beflammung, eine Koronaentladung, eine Plasmabehandlung, eine Laserbehandlung, eine Fluorierung oder eine Silikatisierung. Unter Aktivierung kann jede oxidierende Behandlung mit einer hohen Energie bezeichnet werden, wie eine Behandlung mit Ozon oder auch ein Oxidationsschritt mit Sauerstoff unter Erhitzen auf eine Temperatur, die niedriger als die Schmelztemperatur des Materials des Gehäuses des Identifikationsgebers ist. Diese Vorgänge bzw. Behandlungen zur Aktivierung der Oberfläche des Gehäuses ermöglichen es, beispielsweise Sauerstoff chemisch an den Kunststoff des Gehäuses zu binden.

Wenn man die Oxidation mit Sauerstoff unter Erhitzen bewirkt, bringt man den Bereich vorzugsweise auf eine Temperatur, die 10 bis 140°C niedriger ist als die Schmelztemperatur des Kunststoffmaterials. Dieses Erhitzen kann durch jedes bekannte Mittel durchgeführt werden, beispielsweise durch Infrarotstrahlung oder durch Blasen von Heißluft. Die genannten Vorgänge zur Aktivierung der Oberfläche des Gehäuses können selbstverständlich miteinander kombiniert werden.

In einer weiteren Ausführungsform der Erfindung ist vorgesehen, dass das Gehäuse aus mindestens zwei Einzelschalen ausgeführt ist, wobei die Funktionsbeschichtung auf mindestens einer Einzelschale aufgebracht wird, wobei anschließend die Einzelbauteile des Identifikationsgebers, insbesondere die Einzelschalen und/oder das Tastelement und die Elektronikeinheit zusammengebaut werden. Das bedeutet, dass zunächst die Einzelschale mit der entsprechenden Funktionsbeschichtung versehen wird, bevor der gesamte mobile Identifikationsgeber mit seinen jeweiligen Einzelbauteilen einschließlich Elektronikeinheit etc. zusammengebaut wird. Einer der Vorteile hierbei ist, dass nur die Schale des Identifikationsgebers, die zu bedrucken ist, der Bedruckungsvorrichtung zugeführt wird. Somit müssen nicht die nicht zu bedruckenden Flächen des Gehäuses des Identifikationsgebers aufwendig abgeklebt werden, um wirkungsvoll eine Nichtbedruckung an gewissen Stellen des Gehäuses zu verhindern.

Die Haftschicht und/oder die Schutzschicht und/oder die Farbschicht kann auf diverse Weise am Gehäuse des Identifikationsgebers aufgebracht werden, insbesondere werden die Haftschicht und/oder die Schutzschicht und/oder die Farbschicht gesprüht oder gedruckt. Die Informationsschicht, die durch die Schutzschicht bedeckt ist, wird auf die Haftschicht oder auf die Farbschicht bedruckt.

In einer weiteren bevorzugten Ausführung der Erfindung kann ein Druckkopf zur Aufbringung der Funktionsbeschichtung vorgesehen sein und eine Plattform mit einer Vielzahl an Aufnahmen vorgesehen sein, wobei in jeder Aufnahme ein Gehäuse angeordnet ist, wobei während der Aufbringung der Funktionsbeschichtung der Druckkopf und/oder die Plattform über einen Antrieb bewegt werden, insbesondere der Abstand zwischen dem Druckkopf und der Plattform verändert wird. Hierbei ist es denkbar, dass der Druckkopf während der Aufbringung der Funktionsbeschichtung sich bewegt und die jeweiligen Schichten der Funktionsbeschichtung auf dem Gehäuse aufbringt. Das Gehäuse kann zum einen unbeweglich zum sich bewegenden Druckkopf angeordnet sein. Ebenfalls ist es denkbar, dass das Gehäuse sich ebenfalls entlang einer Achse bewegen kann Zusätzlich ist es denkbar, dass der Abstand zwischen dem Druckkopf und der Plattform, insbesondere dem Gehäuse während der Aufbringung der Funktionsbeschichtung verändert werden kann.

Bei einer Vorrichtung, die nicht Gegenstand der Erfindung ist, kann vorgesehen sein, dass ein Druckkopf zur Aufbringung der Funktionsbeschichtung an einer Außenfläche des Gehäuses vorgesehen ist, wobei der Druckkopf relativ beweglich zum Gehäuse gelagert ist, wobei die Funktionsbeschichtung eine gedruckte Informationsschicht zur Individualisierung des Identifikationsgebers aufweist.

Hierbei kann weiter vorgesehen sein, dass ein Druckkopf zur Aufbringung der Funktionsbeschichtung an einer Außenfläche des Gehäuses vorgesehen ist, wobei der Druckkopf relativ beweglich zum Gehäuse gelagert ist, wobei die Funktionsbeschichtung mindestens zwei Schichten aufweist, wobei eine Informationsschicht zur Individualisierung des Identifikationsgebers vorgesehen ist, auf der eine Schutzschicht angeordnet ist, wobei die Informationsschicht zwischen der Außenfläche des Gehäuses und der Schutzschicht angeordnet ist.

In einer weiteren bevorzugten Ausführungsform der Vorrichtung kann eine Plattform mit einer Vielzahl an Aufnahmen vorgesehen sein, wobei in jeder Aufnahme ein Gehäuse einbringbar ist.

Zudem ist es denkbar, dass die Funktionsbeschichtung einer definierten Strahlungsenergie ausgesetzt ist, die insbesondere eine Belichtungseinheit emittiert. Hierbei dient die Strahlungsenergie zur zuverlässigen Aushärtung der Informationsschicht, die vorzugsweise aus einer lichthärtenden Tinte besteht. Somit kann ein scharfes Druckbild der Informationsschicht erzielt werden. Ferner kann die Belichtungseinheit am Druckkopf angeordnet sein, wodurch eine kompakte Gesamtvorrichtung zur Aufbringung einer Funktionsbeschichtung auf den mobilen Identifikationsgeber geschaffen wird. Vorzugsweise ist die Belichtungseinheit im Druckkopf mitintegriert.

Weitere Vorteile, Merkmale und Einzelheiten der Erfindung ergeben sich aus der nachfolgenden Beschreibung, aus der unter Bezugnahme auf die Zeichnungen mehrere Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine Draufsicht auf einen mobilen Identifikationsgeber,
- Figur 2: eine weitere Ansicht auf einen mobilen Identifikationsgeber,
- Figur 3: eine Schnittansicht entlang des Identifikationsgebers durch seine Funktionsbeschichtung gemäß Figur 1,
- Figur 4: eine weitere Alternative der Schnittansicht gemäß Figur 1,
- Figur 5: eine weitere Alternative der Schnittansicht gemäß Figur 1,
- Figur 6: eine weitere Alternative der Schnittansicht gemäß Figur 1
- Figur 7: eine rein schematische Ansicht auf eine Vorrichtung zur Aufbringung einer Funktionsbeschichtung auf einem mobilen Identifikationsgeber,
- Figur 8: eine weitere Alternative der Schnittansicht gemäß Figur 1,
- Figur 9: eine weitere Alternative der Schnittansicht gemäß Figur 1,
- Figur 10: eine weitere Alternative der Schnittansicht gemäß Figur 1 und
- Figur 11: eine weitere Alternative der Schnittansicht gemäß Figur 1.

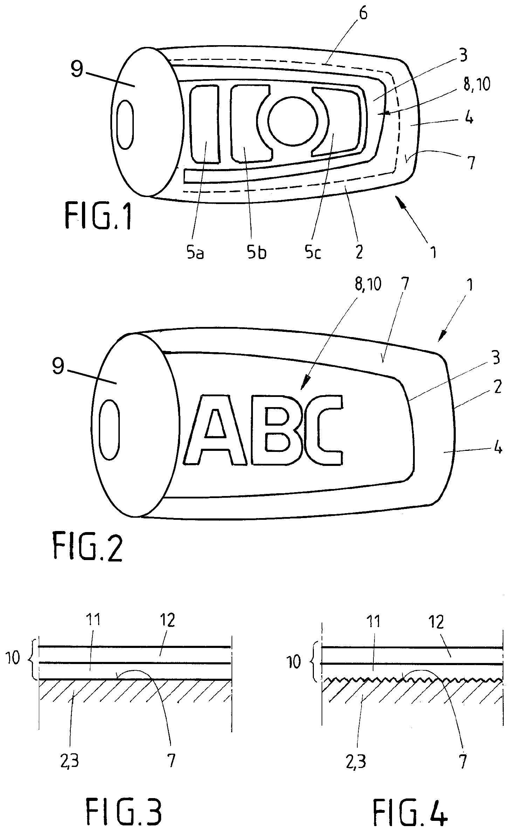

In Figur 1 ist ein mobiler Identifikationsgeber 1 gezeigt, mit dem ein Ent- und Verriegelungsvorgang einer nicht explizit dargestellten Schließvorrichtung eines Kraftfahrzeuges ausgelöst werden kann. Diese Auslösung erfolgt im vorliegenden Ausführungsbeispiel durch eine "schlüssellose" Aktivierung eines im Gehäuse 2 des Identifikationsgebers 1 angeordneten Tastenelements 5a, 5b, 5c. Alternativ können sich sämtliche Figurenbeispiele auf einen Identifikationsgeber 1 beziehen, der tastenlos funktioniert. Unter der Aktivierung kann gleichzeitig ein vorgeschaltetes Zugangskontrollverfahren verstanden werden. Das bedeutet, dass der mobile Identifikationsgeber 1 gespeicherte Identifikationsdaten umfasst, die in der schematisch angedeuteten Elektronikeinheit 6 vorgesehen sind. Diese Elektronikeinheit 6 befindet sich innerhalb des Gehäuses 2 und ist somit vor jeglichen Umwelteinflüssen geschützt. Diese Identifikationsdaten können für die Aktivierung der Schließvorrichtung des Kraftfahrzeuges über eine Sende- und Empfangseinheit des Identifikationsgeber 1 an eine weitere Sende- und Empfangseinheit des nicht dargestellten Kraftfahrzeuges per Funk gesendet werden. Aufgrund einer bidirektionalen Kommunikation zwischen dem Identifikationsgeber 1 und dem Kraftfahrzeug wird ein Öffnungsvorgang und/oder ein Schließvorgang der Schließvorrichtung des Kraftfahrzeuges aktiviert. Dieses ist davon abhängig, inwieweit eine positive Identifikation vorliegt.

Um eine Individualisierung des Identifikationsgebers 1 zu erzielen, ist auf einer definierten Außenfläche 7 des Gehäuses 2 eine Funktionsbeschichtung 10 aufgetragen. Die Funktionsbeschichtung 10 weist gemäß Figur 1 eine Signalfarbe auf, die zumindest teilweise die Tastenelemente 5a, 5b, 5c umfasst. Im vorliegenden Ausführungsbeispiel setzt sich das Gehäuse 2 aus unterschiedlichen Einzelschalen 3, 4, 9 zusammen. Die Außenfläche 7 der Einzelschale 3, die einen u-förmigen Verlauf aufweist, ist vollständig mit der Funktionsbeschichtung 10 versehen.

Figur 2 zeigt eine weitere Ausführungsalternative des Identifikationsgebers 1, wobei die Funktionsbeschichtung 10 eine Beschriftung 8 aufweist. Auch in diesem Ausführungsbeispiel weist die erste Einzelschale 3 die Funktionsbeschichtung 10 auf, wobei die übrigen Einzelschalen 4, 9 frei von jeglicher Funktionsbeschichtung sind. Selbstverständlich ist es in einer weiteren nicht explizit dargestellten Ausführungsvariante denkbar, mehrere Einzelschalen des Gehäuses 2 mit Funktionsbeschichtungen 10 auszuführen.

Gemäß Figur 3 ist eine mögliche Alternative der betreffenden Funktionsbeschichtung 10 dargestellt. Die Funktionsbeschichtung 10 ist auf der Außenfläche 7 des Gehäuses 2 aufgebracht. Hierbei weist die Funktionsbeschichtung 10 eine Informationsschicht 11 auf, die unmittelbar auf der Außenfläche 7 des Gehäuses 2 aufgedruckt ist. Über der Informationsschicht 11 ist eine Schutzschicht 12 aufgebracht. Die Funktionsbeschichtung 10 befindet sich hierbei auf der Einzelschale 3 des Gehäuses 2.

Die in Figur 4 gezeigte Funktionsbeschichtung 10 entspricht im Wesentlichen der Funktionsbeschichtung 10 aus Figur 3. Der Unterschied zu Figur 3 ist lediglich, dass gemäß Figur 4 die Außenfläche des Gehäuses 2 aktiviert ist, um die Benetzbarkeit und/oder das Haftvermögen im Bezug auf die Informationsschicht 11 zu erhöhen. Die Aktivierung des Gehäuses 2 erfolgt durch eine Behandlung der Außenfläche 7 mit einer hohen Energie. Hier bieten sich mindestens eine der folgenden Behandlungsvorgänge an: eine Beflammung, eine Koronaentladung, eine Plasmabehandlung, eine Laserbehandlung, eine Ozonbehandlung, eine Fluorierung oder eine Silikatisierung.

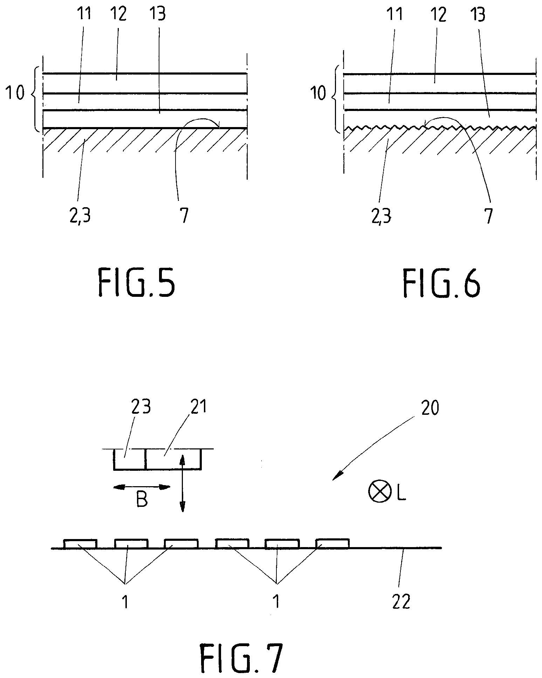

In Figur 5 ist eine Funktionsbeschichtung 10 dargestellt, die aus drei Schichten 11,12,13 besteht. Im vorliegenden Ausführungsbeispiel ist eine auf der Außenfläche 7 des Gehäuses 2 vorgesehene Haftschicht 13 aufgetragen, wobei auf der Haftschicht 13 die Informationsschicht 11 angeordnet ist. Hierbei befindet sich die Informationsschicht 11 zwischen der außen liegenden Schutzschicht 12 und der Haftschicht 13. Die Haftschicht 13 bewirkt ein verstärktes Haftvermögen zwischen der Informationsschicht 11 und der Außenfläche 7.

Die Funktionsbeschichtung 10 gemäß Figur 6 entspricht im Wesentlichen der Funktionsbeschichtung 10 gemäß Figur 5, wobei die Außenfläche 7 des Gehäuses 2 zur Erhöhung des Haftvermögens aktiviert ist. Um Wiederholungen zu vermeiden, wird hier auf die Figur 4 verwiesen. Auf der aktivierten Außenfläche 7 des Gehäuses 2 befindet sich die Haftschicht 13. Auf der Haftschicht 13 ist die Informationsschicht 11 aufgedruckt, wobei auf der Informationsschicht 11 die Schutzschicht 12 aufgetragen ist.

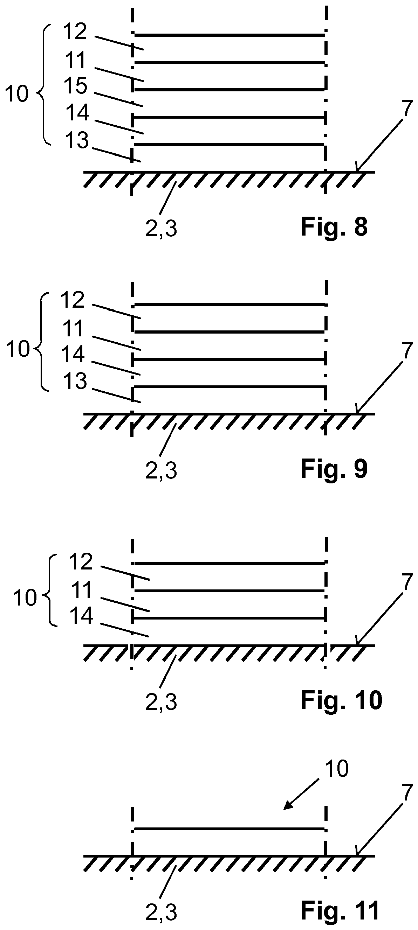

In Figur 8 ist eine Funktionsbeschichtung 10 auf der Außenfläche 7 eines Gehäuses 2 aufgetragen. Diese Funktionsbeschichtung 10 weist 5 Schichten 11,12,13,14,15 auf. Auf der Außenfläche 7 des Gehäuses 2 ist zunächst eine Haftschicht 13 aufgetragen. Darüber befindet sich eine Farbschicht 14. Über der Farbschicht 14 ist eine Schutzschicht 15 aufgetragen. Über der Schutzschicht 15 wird die Informationsschicht 11 aufgedruckt, wobei anschließend über der Informationsschicht 11 eine weitere Schutzschicht 12 aufgetragen ist. Die Farbschicht 14 kann beispielsweise das gesamte Gehäuse 2 oder die jeweilige Einzelschale 3,4 des Gehäuses 2 überziehen. Die Farbschicht 14 kann beispielsweise die Basisfärbung für das Gehäuse 2 darstellen. Oberhalb der Farbschicht 14 erfolgt die Individualisierung über die Informationsschicht 11, die sandwichartig zwischen den beiden Schutzschichten 12,15 positioniert ist.

Gemäß Figur 9 und Figur 10 kann die Farbschicht 14 ebenfalls als Basisfärbung für das Gehäuse 2 dienen. Gemäß Figur 9 befindet sich die Informationsschicht 11 direkt auf der Farbschicht 14, wobei zur Erhöhung des Haftvermögens auch hier eine Haftschicht 13 zum Einsatz kommt, die zwischen der Farbschicht 14 und der Außenfläche 7 des Gehäuses 2 positioniert ist. Oberhalb der Informationsschicht 11 befindet sich wie in Figur 3 bis Figur 6 bzw. Figur 8 die Schutzschicht 12.

Gemäß Figur 10 kommt eine Funktionsbeschichtung 10 zum Einsatz, die im Gegensatz zum Ausführungsbeispiel gemäß Figur 9 ohne Haftschicht auskommt. Das bedeutet, dass die Funktionsbeschichtung 10 aus drei Schichten 11,12,14 besteht, wobei die Farbschicht 14 unmittelbar auf die Außenfläche 7 des Gehäuses 2 aufgetragen ist. Über der Farbschicht 14 ist die Informationsschicht 11 aufgedruckt, die wiederum durch die Schutzschicht 12 geschützt ist.

In Figur 11 ist ein weiteres Ausführungsbeispiel gezeigt, welches eine Funktionsbeschichtung 10 aufweist, die lediglich eine Schicht aufweist. Diese Schicht ist auf das Gehäuse 2 aufgedruckt. Die Besonderheit hier ist, dass diese aufgedruckte Schicht das Material der Schutzschicht und/oder der Informationsschicht und/oder der Farbschicht und/oder der Haftschicht aufweisen kann. Hierdurch ist die Beschichtungszeit der Funktionsbeschichtung wesentlich reduzierbar, wobei gleichzeitig es möglich ist, die Schichtdicke im Vergleich zu den anderen Ausführungsbeispielen zu reduzieren.

Die beschriebenen Funktionsbeschichtungen 10 gemäß Figur 1 bis Figur 6 sowie Figur 8 bis Figur 11 sind zumindest teilweise aufgedruckt, das bedeutet, dass die Informationsschicht 11 beispielsweise über einen in Figur 7 schematisch dargestellten Druckkopf 21 aufgedruckt sind. Die Schichten 12 und/oder 13 können aufgesprüht oder aufgedruckt werden. Hierbei bietet es sich an, eine Vorrichtung 20 zur Aufbringung der Funktionsbeschichtung 10 vorzusehen, die gleichzeitig alle Schichten 11, 12, 13, 14, 15 der Funktionsbeschichtung 10 auf das Gehäuse 2 des mobilen Identifikationsgebers 1 auftragen kann. Gemäß Figur 7 ist der Druckkopf 21 in eine Breitenrichtung B bewegbar. Die Vorrichtung 20 weist des Weiteren eine Plattform 22 auf, die mit einer Vielzahl an Aufnahmen vorgesehen ist, wobei an jeder Aufnahme ein Identifikationsgeber 1 angeordnet ist. Gemäß des Ausführungsbeispiels aus Figur 7 ist auch die Plattform 22 in Zeichenebene, insbesondere entlang einer Längenrichtung L bewegbar. Darüber hinaus kann der Druckkopf 21 in Richtung der Plattform 22 bewegt werden, so dass der Abstand zwischen dem Gehäuse 2 des Identifikationsgebers 1 und dem Druckkopf 21 variiert werden kann. Diese Abstandsänderung kann dann von Vorteil sein, wenn der Identifikationsgeber 1 eine komplizierte Geometrie aufweist. In diesem Fall kann der Druckkopf 21 durch eine entsprechende Abstandsänderung entlang der Oberfläche 7 des Gehäuses 2 nachgeführt werden, um beispielsweise während des gesamten Aufbringens der Funktionsbeschichtung 10 einen konstanten Abstand zwischen dem Druckkopf 21 und der Außenfläche 7 des Gehäuses 2 zu bewirken. Hinsichtlich der Druckqualität ist eine derartige Bewegungsmöglichkeit des Druckkopfes 21 von Vorteil. Selbstverständlich ist es alternativ denkbar, dass über eine Bewegung der Plattform 22 eine Abstandsänderung zum Druckkopf 21 realisiert werden kann.

Bei einfachen Geometrien des Identifikationsgebers 1 kann es ausreichen, dass der Druckkopf 21 lediglich entlang einer ersten Richtung B und die Plattform 22 entlang der Richtung L geführt werden kann. Alternativ ist es denkbar, dass der Druckkopf 21 während der Aufbringung der Funktionsbeschichtung 10 feststeht, und lediglich die Plattform 22 in die entsprechenden Richtungen L, B bewegt wird. Alternativ kann die Plattform 22 feststehen, wobei der Druckkopf 21 entlang der Richtung B und L bewegt werden kann.

Gemäß Figur 7 ist es denkbar, dass eine Belichtungseinheit 23 vorgesehen ist, welche Strahlungsenergie auf die Funktionsbeschichtung 10, insbesondere auf die Informationsschicht 11 oder auf die restlichen Schichten 12,13,14,15 emittiert. Hierdurch kann eine schnellere Aushärtung des Materials der Funktionsbeschichtung 10, insbesondere des Materials der Informationsschicht 11 bewirkt werden. Folglich kann das Druckbild der Funktionsbeschichtung 10 verbessert werden. Vorzugsweise wird für die Informationsschicht 11 eine lichthärtende Tinte verwendet, die durch den Druckkopf 21 auf das Gehäuse 2 gebracht wird.

Um die Benetzbarkeit und/oder das Haftvermögen der Funktionsbeschichtung 10 weiter zu erhöhen, kann es gemäß Figur 1 bis Figur 6 sowie gemäß Figur 8 bis Figur 11 sinnvoll sein, vor einer Aufbringung der Funktionsbeschichtung 10 die Außenfläche 7 des Gehäuses 2 zu reinigen, insbesondere zu entfetten oder gemäß Figur 4 zu aktivieren.

### Bezugszeichenliste

- 1: Mobiler Identifikationsgeber
- 2: Gehäuse
- 3: erste Einzelschale
- 4: zweite Einzelschale
- 5a, 5b, 5c: Tastenelement
- 6: Elektronikeinheit
- 7: Außenfläche von 2,3
- 8: Beschriftung, Logoelement
- 9: dritte Einzelschale

- 10: Funktionsbeschichtung
- 11: Informationsschicht
- 12: Schutzschicht
- 13: Haftschicht
- 14: Farbschicht
- 15: Schutzschicht

- 20: Vorrichtung
- 21: Druckkopf
- 22: Plattform
- 23: Belichtungseinheit

## Patentansprüche

1. Mobiler Identifikationsgeber (1) zur Ent- und Verriegelung einer Schließvorrichtung eines Kraftfahrzeuges, mit
einer Elektronikeinheit (6), die innerhalb eines Gehäuses (2) angeordnet ist, wobei das Gehäuse (2) eine definierte Außenfläche (7) aufweist, auf der eine Funktionsbeschichtung (10) aufgebracht ist, wobei die Funktionsbeschichtung (10) mindestens eine Schicht (11,12,13,14,15) aufweist, wobei eine aufgedruckte Informationsschicht (11) zur Individualisierung des Identifikationsgebers (1) enthalten ist, wobei die Funktionsbeschichtung (10) eine Schutzschicht (12) aufweist, die auf der Informationsschicht (11) angeordnet ist, so dass die Informationsschicht (11) zwischen der Außenfläche (7) des Gehäuses (2) und der Schutzschicht (12) angeordnet ist, wobei die Funktionsschicht (10) eine weitere Schutzschicht (15) aufweist, die unterhalb der Informationsschicht (11) angeordnet ist, so dass die Informationsschicht (11) zwischen beiden Schutzschichten (12,15) positioniert ist, wobei die Funktionsbeschichtung (10) eine Farbschicht (14) aufweist, wobei die Farbschicht (14) unmittelbar auf der Außenfläche (7) des Gehäuses (2) aufgetragen ist.

2. Mobiler Identifikationsgeber (1) nach Anspruch 1,
**dadurch gekennzeichnet,**
**dass** die Funktionsbeschichtung (10) eine Haftschicht (13) aufweist.

3. Mobiler Identifikationsgeber (1) nachAnspruch 1,
**dadurch gekennzeichnet,**
**dass** die Funktionsbeschichtung (10) eine aufgedruckte Schicht ist, in der das Material der Schutzschicht (12,15) und/oder der Informationsschicht (11) und/oder der Farbschicht (14) und/oder der Haftschicht (13) integriert ist.

4. Mobiler Identifikationsgeber (1) nach einem der vorhergehenden Ansprüche,
**dadurch gekennzeichnet,**
**dass** das Gehäuse (2) mindestens ein Tastenelement (5a,5b,5c) zum Auslösen einer definierten Funktion aufweist.

5. Mobiler Identifikationsgeber (1) nach einem der vorhergehenden Ansprüche,
**dadurch gekennzeichnet,**
**dass** die Oberfläche der Außenfläche (7) des Gehäuses (2) derart aktiviert ist, dass die Benetzbarkeit und/oder das Haftvermögen, insbesondere im Bezug auf die Farbschicht (14) erhöht ist.

6. Mobiler Identifikationsgeber (1) nach einem der vorhergehenden Ansprüche,
**dadurch gekennzeichnet,**
**dass** die Funktionsbeschichtung (10) zumindest teilweise aufgedruckt ist,

7. Mobiler Identifikationsgeber (1) nach einem der vorhergehenden Ansprüche,
**dadurch gekennzeichnet,**
**dass** das Gehäuse (2) aus mindestens einer ersten und einer zweiten Einzelschale (3, 4) ausgeführt ist, wobei die Außenfläche (7) der ersten Einzelschale (3) die Funktionsbeschichtung (10) aufweist.

8. Mobiler Identifikationsgeber (1) nachAnspruch 1,
**dadurch gekennzeichnet,**
**dass** die Schutzschicht (12,15) zumindest teilweise transparent ausgeführt ist.

9. Verfahren zur Herstellung eines mobilen Identifikationsgebers (1) nach einem der Ansprüche 1 bis 8, zur Ent- und Verriegelung einer Schließvorrichtung eines Kraftfahrzeuges, mit einer Elektronikeinheit (6), die innerhalb eines Gehäuses (2) angeordnet ist, aufweisend
**folgende Schritte:**
a) Bereitstellen eines Gehäuses (2), das ein Spritzgussteil aus Kunststoff ist,
b) Aufbringen einer Funktionsbeschichtung (10) auf eine definierte Außenfläche (7) des Gehäuses (2), wobei
eine Informationsschicht (11) zur Individualisierung des Identifikationsgebers (1) aufgedruckt wird, wobei die Funktionsbeschichtung (10) eine Schutzschicht (12) aufweist, die auf der Informationsschicht (11) angeordnet wird, so dass die Informationsschicht (11) zwischen der Außenfläche (7) des Gehäuses (2) und der Schutzschicht (12) angeordnet wird, wobei die Funktionsschicht (10) eine weitere Schutzschicht (15) aufweist, die unterhalb der Informationsschicht (11) angeordnet wird, so dass die Informationsschicht (11) zwischen beiden Schutzschichten (12,15) positioniert wird.

10. Verfahren nach Anspruch 9,
**dadurch gekennzeichnet,**
**dass** vor dem Schritt b) (1) folgender Schritt durchgeführt wird:
d) Reinigen, insbesondere Entfetten der Außenfläche (7) des Gehäuses (2).

11. Verfahren nach einem der Ansprüche 9-10, **dadurch gekennzeichnet,**
**dass** vor dem Schritt b) folgender Schritt durchgeführt wird, insbesondere vor dem Schritt c) und/oder nach dem Schritt d) folgender Schritt durchgeführt wird:
e) Aktivierung der Oberfläche der Außenfläche (7) des Gehäuses (2), wodurch die Benetzbarkeit und/oder das Haftvermögen, insbesondere im Bezug auf die Farbschicht (14) erhöht wird.

12. Verfahren nach Anspruch 9, **dadurch gekennzeichnet,**
**dass** nach dem Schritt c) und vor dem Schritt b) (1) folgender Schritt durchgeführt wird:
f) Aufbringen einer Schutzschicht (15) auf die Farbschicht (14) oder auf die Haftschicht (13).

13. Verfahren nach einem der Ansprüche 9-12, **dadurch gekennzeichnet,**
**dass** sämtliche Schichten (11,12,13,14,15) gedruckt werden und/oder dass die Funktionsschicht (10) als eine Schicht gedruckt wird, die das Material der Schutzschicht (12,15) und/oder der Informationsschicht (11) und/oder der Farbschicht (14) und/oder der Haftschicht (13) aufweist.

14. Verfahren nach einem der Ansprüche 9-13, **dadurch gekennzeichnet,**
**dass** das Gehäuse (2) aus mindestens zwei Einzelschalen (3, 4, 9) ausgeführt ist, wobei die Funktionsbeschichtung (10) auf mindestens einer Einzelschale (3, 4, 9) aufgebracht wird, wobei anschließend die Einzelbauteile des Identifikationsgebers (1), insbesondere die Einzelschalen (3, 4, 9), das Tastenelement (5a, 5b, 5c) und die Elektronikeinheit (6) zusammengebaut werden.

15. Verfahren nach einem der Ansprüche 9-14, **dadurch gekennzeichnet,**
**dass** ein Druckkopf (21) zur Aufbringung der Funktionsbeschichtung (10) vorgesehen ist wobei insbesondere eine Plattform (22) mit einer Vielzahl an Aufnahmen vorgesehen ist, wobei in jeder Aufnahme ein Gehäuse (2) angeordnet ist, wobei während der Aufbringung der Funktionsbeschichtung (10) der Druckkopf (21) und/oder die Plattform (22) über einen Antrieb bewegt werden, insbesondere der Abstand zwischen dem Druckkopf (21) und der Plattform (22) verändert wird.

## Claims

1. A mobile identification transmitter (1) for unlocking and locking a locking device of a motor vehicle, having
an electronic unit (6) which is arranged inside a housing (2),
**characterized in that**
the housing (2) has a defined outer surface (7) onto which a functional coating (10) is applied, wherein the functional coating (10) has at least one layer (11, 12, 13, 14, 15), wherein a printed information layer (11) is included for the purpose of individualizing the identification transmitter (1), wherein
the functional coating (10) has a protective layer (12) which is arranged on the information layer (11), such that the information layer (11) is arranged between the outer surface (7) of the housing (2) and the protective layer (12), wherein
the functional layer (10) has a further protective layer (15) which is arranged beneath the information layer (11) such that the information layer (11) is positioned between both protective layers (12, 15), wherein
the functional coating (10) has a color layer (14), wherein
the color layer (14) is directly applied to the outer surface (7) of the housing (2).

2. A mobile identification transmitter (1) according to claim 1,
**characterized in that**
the functional coating (10) has an adhesive layer (13).

3. A mobile identification device (1) according to claim 1,
**characterized in that**
the functional coating (10) is a printed layer in which the material of the protective layer (12, 15) and/or the information layer (11) and/or the color layer (14) and/or the adhesive layer (13) is integrated.

4. A mobile identification device (1) according to one of the previous claims,
**characterized in that**
the housing (2) has at feast one button element (5a, 5b, 5c) for the purpose of initiating a defined function.

5. A mobile identification device (1) according to one of the previous claims,
**characterized in that**
the surface of the outer surface (7) of the housing (2) is activated in such a manner that the wettability and/or the adhesive strength, particularly with respect to the color layer (14) is increased.

6. A mobile identification device (1) according to one of the previous claims,
**characterized in that**
the functional coating (10) is at least partially printed-on.

7. A mobile identification device (1) according to one of the previous claims,
**characterized in that**
the housing (2) is constructed of at least one first and one second separate shell (3, 4), wherein the outer surface (7) of the first separate shell (3) has the functional coating (10).

8. A mobile identification device (1) according to claim 1,
**characterized in that**
the protective layer (12, 15) is designed as at least partially transparent.

9. A method for the production of a mobile identification transmitter (1) according to one of the claims 1 to 8, for the purpose of unlocking and locking a lock device of a motor vehicle, having
an electronic unit (6) which is arranged inside a housing (2),
**comprising the following steps:**
a) provision of a housing (2) which is a plastic injection molded part,
b) application of a functional coating (10) to a defined outer surface (7) of the housing (2), wherein
(1) an information layer (11) is printed-on for the purpose of individualizing the identification transmitter (1) wherein
the functional coating (10) has a protective layer (12) which is arranged on the information layer (11), such that the information layer (11) is arranged between the outer surface (7) of the housing (2) and the protective layer (12), wherein
the functional layer (10) has a further protective layer (15) which is arranged beneath the information layer (11) such that the information layer (11) is positioned between both protective layers (12, 15).

10. A method according to one of the previous claims,
**characterized in that**
prior to step b) (1), the following step is carried out:
d) cleaning, particularly degreasing, of the outer surface (7) of the housing (2).

11. A method according to one of claims 9 to 10,
**characterized in that**
prior to step b), the following step is carried out, particularly prior to step c) and/or following step d) the following step is carried out:
e) activation of the surface of the outer surface (7) of the housing (2), whereby the wettability and/or the adhesive strength, particularly with respect to the color layer (14) is increased.

12. A method according to claim 9,
**characterized in that**
after step c) and prior to step b) (1), the following step is carried out:
f) application of a protective layer (15) onto the color layer (14) or onto the adhesive layer (13).

13. A method according to one of claims 9 to 12,
**characterized in that**
all layers (11, 12, 13, 14, 15) are printed and/or **in that** the functional layer (10) is printed as a layer which comprises the material of the protective layer (12, 15) and/or the information layer (11) and/or the color layer (14) and/or the adhesive layer (13).

14. A method according to claims 9 to 13,
**characterized in that**
the housing (2) is constructed from at least two separate shells (3, 4, 9), and the functional coating (10) is applied on at least one separate shell (3, 4, 9), wherein subsequently the individual components of the identification transmitter (1), particularly the separate shells (3, 4, 9), the button element (5a, 5b, 5c), and the electronic unit (6) are assembled.

15. A method according to one of the previous claims,
**characterized in that**
a print head (21) is included for the purpose of applying the functional coating (10), wherein particularly a platform (22) having a plurality of receptacles is provided, wherein one housing (2) is arranged in each receptacle, wherein the print head (21) and/or the platform (22) are moved via a drive during the application of the functional coating (10), and particularly the distance between the print head (21) and the platform (22) is changed.

## Revendications

1. Émetteur d'identification mobile (1) destiné au déverrouillage et au verrouillage d'un dispositif de fermeture d'un véhicule automobile, comprenant une unité électronique (6), qui est disposée dans un boîtier (2), dans lequel le boîtier (2) comporte une surface extérieure (7) définie, sur laquelle un revêtement fonctionnel (10) est appliqué, le revêtement fonctionnel (10) comportant au moins une couche (11, 12, 13, 14, 15), une couche d'information (11) imprimée étant inclue pour la personnalisation de l'émetteur d'identification (1), le revêtement fonctionnel (10) comportant une couche de protection (12), qui est disposée sur la couche d'information (11), de telle sorte que la couche d'information (11) est disposée entre la surface extérieure (7) du boîtier (2) et la couche de protection (12), le revêtement fonctionnel (10) comportant une autre couche de protection (15), qui est disposée sous la couche d'information (11), de telle sorte que la couche d'information (11) est positionnée entre les deux couches de protection (12, 15), le revêtement fonctionnel (10) comportant une couche de peinture (14), la couche de peinture (14) étant appliquée directement sur la surface extérieure (7) du boîtier (2).

2. Émetteur d'identification mobile (1) selon la revendication 1,
**caractérisé en ce que**
le revêtement fonctionnel (10) comporte une couche d'adhérence (13).

3. Émetteur d'identification mobile (1) selon la revendication 1,
**caractérisé en ce que**
le revêtement fonctionnel (10) est une couche imprimée, dans laquelle le matériel de la couche de protection (12, 15) et/ou de la couche d'information (11) et/ou de la couche de peinture (14) et/ou de la couche d'adhérence (13) est intégré.

4. Émetteur d'identification mobile (1) selon l'une des revendications précédentes,
**caractérisé en ce que**
le boîtier (2) comporte au moins un élément en forme de touche (5a, 5b, 5c) pour déclencher une fonction définie.

5. Émetteur d'identification mobile (1) selon l'une des revendications précédentes,
**caractérisé en ce que**
la surface de la surface extérieure (7) du boîtier (2) est activée de telle manière que la mouillabilité et/ou le pouvoir d'adhérence est augmentée, en particulier par rapport à la couche de peinture (14).

6. Émetteur d'identification mobile (1) selon l'une des revendications précédentes,
**caractérisé en ce que**
le revêtement fonctionnel (10) est au moins partiellement imprimé.

7. Émetteur d'identification mobile (1) selon l'une des revendications précédentes,
**caractérisé en ce que**
le boîtier (2) est réalisé à partir d'au moins une première et une seconde coque individuelle (3, 4), la surface extérieure (7) de la première coque individuelle (3) comportant le revêtement fonctionnel (10).

8. Émetteur d'identification mobile (1) selon la revendication 1,
**caractérisé en ce que**
la couche de protection (12, 15) est réalisée au moins partiellement transparente.

9. Procédé de fabrication d'un émetteur d'identification mobile (1) selon l'une des revendications 1 à 8, destiné au déverrouillage et au verrouillage d'un dispositif de fermeture d'un véhicule automobile, avec une unité électronique (6), qui est disposée dans un boîtier (2),
comprenant les étapes suivantes :
a) fourniture d'un boîtier (2), qui est une pièce moulée par injection en matière plastique,
b) application d'un revêtement fonctionnel (10) sur une surface extérieure (7) définie du boîtier (2),
une couche d'information (11) étant imprimée pour la personnalisation de l'émetteur d'identification (1), le revêtement fonctionnel (10) comportant une couche de protection (12), qui est disposée sur la couche d'information (11), de telle sorte que la couche d'information (11) est disposée entre la surface extérieure (7) du boîtier (2) et la couche de protection (12), le revêtement fonctionnel (10) comportant une autre couche de protection (15), qui est disposée sous la couche d'information (11), de telle sorte que la couche d'information (11) est positionnée entre les deux couches de protection (12, 15).

10. Procédé selon la revendication 9,
**caractérisé en ce que,**
avant l'étape b) (1) l'étape suivante est effectuée :
d) nettoyage, en particulier dégraissage de la surface extérieure (7) du boîtier (2).

11. Procédé selon l'une des revendications 9 à -10,
**caractérisé en ce que,**
avant l'étape b), l'étape suivante est effectuée, en particulier avant l'étape c) et/ou après l'étape d), l'étape suivante est effectuée :
e) activation de la surface de la surface extérieure (7) du boîtier (2), moyennant quoi la mouillabilité et/ou le pouvoir d'adhérence est augmentée en particulier par rapport à la couche de peinture (14).

12. Procédé selon la revendication 9,
**caractérisé en ce que,**
après l'étape c) et avant l'étape b) (1), l'étape suivante est effectuée :
f) application d'une couche de protection (15) sur la couche de peinture (14) ou sur la couche d'adhérence (13).

13. Procédé selon l'une des revendications 9 à 12,
**caractérisé en ce que**
toutes les couches (11, 12, 13, 14, 15) sont imprimées et/ou **en ce que** la couche fonctionnelle (10) est imprimée comme une couche, qui comporte le matériel de la couche de protection (12, 15) et/ou de la couche d'information (11) et/ou de la couche de peinture (14) et/ou de la couche d'adhérence (13).

14. Procédé selon l'une des revendications 9 à 13,
**caractérisé en ce que**
le boîtier (2) est réalisé à partir d'au moins deux coques individuelles (3, 4, 9), le revêtement fonctionnel (10) étant appliqué sur au moins une coque individuelle (3, 4, 5), les éléments individuels de l'émetteur d'identification (1), en particulier les coques individuelles (3, 4, 9), l'élément en forme de touche (5a, 5b, 5c) et l'unité électronique (6), étant ensuite assemblés.

15. Procédé selon l'une des revendications 9 à 14,
**caractérisé en ce que**
une tête d'impression (21) est prévue pour appliquer le revêtement fonctionnel (10), une plateforme (22) étant en particulier prévue d'une pluralité de logements, un boîtier (2) étant disposé dans chaque logement, la tête d'impression (21) et/ou la plateforme (22) étant déplacée par le biais d'un entraînement pendant l'application du revêtement fonctionnel (10), l'écart entre la tête d'impression (21) et la plateforme (22) étant en particulier modifié.
